# EUROPÄISCHE PATENTSCHRIFT

(11) **EP 1 859 228 B1**
(45) Veröffentlichungstag und Bekanntmachung des Hinweises auf die Patenterteilung: **09.09.2009**
(21) Anmeldenummer: 06707214.0
(22) Anmeldetag: 23.02.2006
(51) Int. Cl.: G01B 11/06, C23C 14/54

(54) **MESSANORDNUNG UND VERFAHREN ZUM OPTISCHEN MONITORING VON BESCHICHTUNGSPROZESSEN**
MEASURING ARRANGEMENT AND METHOD FOR THE OPTICAL MONITORING OF COATING PROCESSES
DISPOSITIF DE MESURE ET PROCEDE POUR UN CONTROLE OPTIQUE DE PROCESSUS DE REVETEMENT

(30) Priorität: 09.03.2005 DE 102005010681
(43) Veröffentlichungstag der Anmeldung: 28.11.2007
(73) Patentinhaber: Leybold Optics GmbH, 63755 Alzenau (DE)
(72) Erfinder: ZÖLLER, Alfons, 63628 Bad Soden Salmünster (DE); HAGEDORN, Harro, 60435 Frankfurt am Main (DE); KLUG, Werner, 63579 Freigericht (DE)
(74) Vertreter: Pohlmann, Bernd Michael
(86) Internationale Anmeldenummer: PCT/EP2006/001667
(87) Internationale Veröffentlichungsnummer: WO 2006/094647

(56) Entgegenhaltungen:
- EP-A- 1 251 189
- EP-A- 1 359 236
- FR-A- 2 281 996
- US-A- 4 878 755
- US-A1- 2003 085 115

## Beschreibung

Die Erfindung betrifft eine Messanordnung und ein Verfahren zum optischen Monitoring von Beschichtungsprozessen in einer Vakuumkammer, insbesondere zur Schichtdickenmessung von auf Substrate aufgebrachten Schichten während des Beschichtungsprozesses, welche ein System zur Lichteinkopplung und eine Lichtempfängereinrichtung umfasst.

Bei Substraten, die zur Erzielung vorgegebener optischer Eigenschaften mit dünnen Schichten in der Größenordnung von Lichtwellenlängen beschichtet werden, müssen zur Erzielung vorgegebener Transmissions- oder Reflexionseigenschaften die Schichten mit hoher Gleichmäßigkeit und genauer Schichtdicke aufgebracht werden. Die Schichtdicke wird über Transmissions- oder Reflexionsmessungen ermittelt und erfolgt in-situ, um den Beschichtungsprozess genau zu steuern. Zur Messung derartig dünner Schichtdicken werden vielfach Fotometer verwendet, die in einer Messphase ein monochromatisches Transmissions- oder Reflexionssignal des beschichteten Substrates und ein Referenzsignal der Lichtquelle des Fotometers erfassen. Derartige Photometeranordnungen haben jedoch den Nachteil, dass die Signale von zwei unterschiedlichen Detektoren erfasst werden, deren Driften das Messergebnis beeinflusst, wobei außerdem Änderungen der Farbtemperatur der Lichtquelle nur mangelhaft berücksichtigt werden können.

Zur Beseitigung dieser Nachteile wird in der EP 0 257 229 B1 vorgeschlagen, mittels eines Choppers zeitlich nacheinander eine Messphase in einer ersten Lichtleitung, eine Referenzphase in einer weiteren Lichtleitung und eine Dunkelphase zu erzeugen. Die Erfassung der Lichtsignale in der Mess- und Referenzphase erfolgt mit einem gemeinsamen Lichtdetektor bei der gleichen, über einen Monochromator eingestellten Wellenlänge, sodass Alterserscheinungen und Temperaturdrift von Lichtquelle und Detektor kompensiert werden können. Die Dunkelphase dient der Kompensation von Fehlern durch Fremdeinflüsse und durch Driften von elektronischen Verstärkern. Die Auswertung der Signale erfolgt mit einer Prozessoreinheit.

In der EP-A-1 251 189 ist eine Messanordnung zum optischen Monitoring von Beschichtungsprozessen in einer Vakuumkammer beschrieben, bei der eine zu messende Testschicht auf eine drehbare Scheibe aufgebracht wird, die vom eigentlich zu beschichtenden Substrat getrennt ist. Die aufgebrachte Schicht wird durch Drehen der Scheibe in einen Messbereich gebracht, der durch eine Blende von der Beschichtungsquelle abgeschattet ist. Die Schichtdickenmessung erfolgt optisch mittels eines Lichtsenders und einer Lichtempfängereinheit, die beide ausserhalb der Vakuumkammer angeordnet sind und über Lichtleitfasern mit dem Messbereich in der Vakuumkammer in Verbindung stehen.

In der US-A-2003 085 115 ist eine Messanordnung zum optischen Monitoring von Beschichtungsprozessen in einer Vakuumkammer beschrieben, bei der über der Beschichtungsquelle eine drehbare Blende angeordnet ist, welche die Beschichtungsquelle abdecken kann. Ein drehbarer Substrathalter mit den zu beschichtenden Substraten ist so über der Beschichtungsquelle angeordnet, dass jeweils nur ein Bereich des Substrathalters über der Beschichtungsquelle steht. In einem durch Blenden von der Beschichtungsquelle abgeschatteten Bereich des Substrathalters erfolgt die optische Schichtdickenmessung mittels eines Lichtsenders und einer Lichtempfängereinheit, die beide innerhalb der Vakuumkammer angeordnet sind.

Die bekannten Messanordnungen für optische Monitoringsysteme können relativ problemlos in Sputteranlagen mit rotierenden, flachen Substrathaltern und intermittierender Beschichtung eingesetzt werden, da aufgrund des geringen Abstandes zwischen Beschichtungsquelle und Substrat der Lichtweg innerhalb der Vakuumkammer sehr kurz ist, eine einfache räumliche Trennung von Beschichtungsquelle und Messanordnung möglich ist und eine einfache Anordnung der Lichtquelle und des Lichtempfängers außerhalb der Vakuumkammer möglich ist.

Erfolgt die Beschichtung in einer Vakuumkammer einer Aufdampfanlage und/oder mittels eines plasma- oder ionenstrahlunterstützten Prozesses, liegen die Beschichtungs-, Ionen- oder Plasmaquelle in größerer Entfernung zum Substrat, so dass die Vakuumkammer wesentlich größer ist und der Lichtweg für Transmissionsmessungen verlängert ist. Es gelangt daher nur ein geringer Teil des Lichtes der Lichtquelle zum Lichtempfänger und die Messung wird durch Fremdlicht der Beschichtungs-, lonen- oder Plasmaquelle gestört.

Aufgabe der Erfindung ist es daher, eine einfache und für Aufdampfanlagen und/oder Anlagen für plasma- oder ionenstrahlunterstützte Beschichtungsprozesse geeignete Messanordnung zum optischen Monitoring mit einer hohen Messgenauigkeit für Transmissionsmessungen von auf bewegten Substrathaltern angeordneten Substraten sowie ein entsprechendes Verfahren zur Verfügung zu stellen.

Die Lösung der Aufgabe gelingt mit den Merkmalen der unabhängigen Ansprüche.

Die Messanordnung zum in-situ Monitoring ermöglicht Transmissionsmessungen an Substraten in Vakuum-Beschichtungsanlagen, in denen eine kontinuierliche Beschichtung mittels Verdampfen eines Beschichtungsmaterials, beispielsweise Elektronenstrahlverdampfen oder mittels plasma- oder ionenstrahlunterstützter PVD- oder CVD-Prozesse erfolgt. Die Messanordnung ermöglicht dabei eine einfache Trennung von Messung und Beschichtung auch während eines kontinuierlichen Beschichtungsprozesses. Eine Anordnung des Lichtsenders dicht unterhalb des Substrathalters ermöglicht dabei kurze Lichtwege und damit eine hohe Lichtausbeute und ein geringes Signalrauschen.

Mit der Anordnung der Lichtempfängereinheit außerhalb der Vakuumkammer ist die Messanordnung insbesondere für Prozesse geeignet, die bei hohen Prozesstemperaturen ablaufen. Dabei ist die Messanordnung relativ unempfindlich gegen mechanisches Verziehen des Vakuum kessels oder lokale Verschiebungen der einzelnen Bauteile beim Evakuieren, Heizen und Betreiben der Verdampferquellen und/oder Ionen- oder Plasmaquellen. Die Blende schützt dabei den Lichtsender und das Messfenster der Vakuumkammer vor unerwünschter Beschichtung und verhindert Fremdlichteinflüsse in der Messanordnung durch die Beschichtungsquelle und/oder Plasma- oder Ionenquellen.

In der Vakuumkammer ist ohnehin eine zwischen Beschichtungsquelle und Substrathalter angeordnete Blende zur Abschattung bzw. Schichtdickenverteilung vorgesehen, die gleichzeitig als Blende für die Messanordnung genutzt wird.

In einer vorteilhaften Ausgestaltung ist der Lichtsender direkt auf der der Beschichtungsquelle abgewandten Seite der Blende befestigt, wodurch zusätzliche Befestigungsmittel entfallen.

Rotiert der, vorzugsweise als sphärische Kalotte ausgebildete, Substrathalter während der Beschichtung um eine Achse, sind die Substrate oder zumindest ein Substrat für die Transmissionsmessung vorzugsweise auf einem Radius des Substrathalters angeordnet, wobei nicht ausgeschlossen ist, dass weitere Substrate zur Beschichtung außerhalb dieses Radius auf der Kalotte angeordnet sind. Der Lichtsender ist dabei so unterhalb des Substrathalters angeordnet, dass die auf dem Radius befindlichen Substrate bei einer Rotation des Substrathalters den Strahlengang zwischen Lichtsender und Lichtempfängereinheit kreuzen und eine intermittierende Transmissionsmessung bei jeder Umdrehung durchgeführt werden kann.

Der Lichtsender ist als direkt in der Vakuumkammer angeordnete Lichtquelle ausgebildet. Die Stromzuführung zur Lichtquelle erfolgt vorzugsweise über eine bereits vorhandene Vakuumstromdurchführung der Vakuumkammer.

Die Messanordnung weist vorzugsweise eine breitbandige Lichtquelle, insbesondere eine Halogenlampe auf, so dass ein breitbandiges Monitoring für optische Beschichtungen, vorzugsweise im Spektralbereich zwischen 400 nm und 1800 nm möglich ist. Weiterhin ist es zum Schutz der Lichtquelle in der Vakuumkammer vorteilhaft, diese in einem Gehäuse anzuordnen. Das Gehäuse kann in weiterer vorteilhafter Ausgestaltung zur Erhöhung der Lichtausbeute der Lichtquelle einen Kollimator, eine abbildende Optik und/oder einen Reflektor aufweisen.

Da eine Halogenlampe Licht im Bereich ca. 350 nm bis 3000 nm emmitiert ist eine Begrenzung des Spektralbereiches für das Monitoring hauptsächlich durch den verwendeten Lichtdetektor, insbesondere durch dessen Signalrauschen, vorgegeben. Mit Standard Si Lichtdetektoren werden beispielsweise gute Signal-Rauschverhältnisse im Bereich von 400 nm bis 1100 nm erreicht. Mit Standard InGaAs Lichtdetektoren kann der Bereich 1000 nm bis 1700 nm problemlos detektiert werden. Für den UV Bereich (350 nm bis 400nm) wäre beispielsweise ein PMT Lichtdetektor geeignet.

Zum Empfang des vom Lichtsender ausgesandten Lichtes ist die Lichtempfängereinheit außerhalb der Vakuumkammer im Strahlengang des Lichtsenders über einem Messfenster der Vakuumkammer angeordnet*.*

In einer weiteren vorteilhaften Ausführungsform der Erfindungen ist die Lichtempfängereinheit mit einer Lichtdetektoreinheit verbunden, wobei die Lichtdetektoreinheit einen Lichtdetektor und ein dispersives Element, insbesondere einen Monochromator umfasst. Über das dispersive Element ist die Lichtwellenlänge des dem Lichtdetektor zugeführten Lichts einstellbar, so dass spektralphotometrische Messungen möglich sind. Anstatt des Monochromators kann auch ein Polychromator mit einem Zeilen-Lichtdetektor verwendet werden. Dabei wird eine Dioden- oder CCD Zeile von einem optischen Gitter beleuchtet. Jedes Einzelelement des Zeilen-Lichtdetektors wird mit einer anderen Wellenlänge beleuchtet. Damit ist ein ganzen Wellenlängenspektrum simultan messbar und ein breitbandiges Monitoring möglich.

Zur weiteren Verarbeitung der vom Lichtdetektor detektierten Lichtintensitäten werden die am Ausgang des Lichtdetektors anliegenden Signale vorzugsweise verstärkt und mittels eines A/D-Wandlers digitalisiert und zur weiteren Verarbeitung an die mit der Lichtdetektoreinheit verbundene Prozessoreinheit übergeben.

Die Lichtempfängereinheit ist über dem Messfenster der Vakuumkammer so angeordnet und ausgerichtet, dass diese das Licht des Lichtsenders empfangen kann. Zur genauen Ausrichtung der Lichtempfängereinheit auf den Strahlengang des Lichtsenders ist die vorzugsweise mit der Vakuumkammer verbundene Lichtempfängereinheit mit Mitteln zum Justieren, insbesondere mit einer Halterung ausgestattet, die auf der Vakuumkammer angebracht werden kann und ein Verkippen der Lichtempfängereinheit um mindestens eine Achse erlaubt.

Um eine genaue Schichtdickenmessung von aufgedampften Schichten auf den Substraten während des Beschichtungsprozesses zu ermöglichen, ist es vorteilhaft, die Lichtintensität der Lichtquelle in einer Referenzphase, die Lichtintensität des von dem Substrat transmittierten Lichts in einer Messphase und eine Restlichtintensität in zumindest einer Dunkelphase nacheinander mit einem Lichtdetektor zu erfassen und daraus einen Wert für die Transmission des beschichteten Substrates abzuleiten. Aus den erfassten Werte wird vorzugsweise jeweils ein Differenzwert aus Mess- und Dunkelphase sowie aus Referenz- und Dunkelphase gebildet. Das Verhältnis zwischen den so ermittelten Differenzwerten (Iₘₑₛₛ-I_{dunkel}/I_{ref}-I_{dunkel}) bildet dann ein Maß für die Transmission des beschichteten Substrates. Damit können Schwankungen der Lichtquelle und der Detektorempfindlichkeit kompensiert werden.

In einer vorteilhaften Ausführungsform der Messanordnung ist der Substrathalter zur Einstellung der Mess-, Referenz- und Dunkelphase ausgebildet. Der Substrathalter weist dazu zumindest eine Aussparung zur Freigabe eines Referenzlichtweges und zumindest einen Dunkelbereich zur Unterbrechung des Strahlengangs zwischen der Lichtquelle und der Lichtempfängereinheit auf.

Weiterhin ist es vorteilhaft, wenn die Prozessoreinheit mit einem Drehantrieb des rotierenden Substrathalters zur Erfassung der Position des auf dem Substrathalter angeordneten Substrates für die Messphase, der Position der Aussparung für die Referenzphase und der Position eines Dunkelbereiches für die Dunkelphase verbunden ist. Das ist vorzugsweise über einen mit dem Drehantrieb gekoppelten Inkrementalgeber möglich, der bei jeder Umdrehung an einem definierten Drehwinkel einen Zähler auf einen definierten Wert setzt und in Abhängigkeit des Drehwinkels Pulse an den Zähler sendet. Dem Zählerstand kann damit immer ein Drehwinkel und damit die Position des Substrates, der Aussparung und des Dunkelbereiches zugeordnet werden. Der Zählerstand wird von der Prozessoreinheit ausgewertet und daraus Signale zur Ansteuerung der Lichtdetektoreinheit zur Erfassung von Messwerten in der Referenz-, Mess- und Dunkelphase abgeleitet.

Die Erfindung wird im weiteren an Hand eines Ausführungsbeispiels näher erläutert. Es zeigen dazu:
- Figur 1: eine schematische Darstellung einer beispielhaften Messanordnung
- Figur 2: Segment eines Substrathalters zur Ausführung einer Mess-, Referenz- und Dunkelmessung

Die beispielhafte Messanordnung wird für eine Transmissionsmessung von in einer Vakuumkammer **1** einer Aufdampfanlage beschichteter Substrate **3** beschrieben. Die zu beschichtenden Substrate **3** sind auf einem kalottenförmigen Substrathalter **2** angeordnet, der während der Beschichtung der Substrate **3** über einer Beschichtungsquelle (nicht dargestellt) um eine Achse **7** rotiert. Zur Optimierung der Schichtdickenverteilung ist unterhalb des Substrathalters **2** eine Blende **5** starr an der Vakuumdurchführung für den Drehantrieb des Substrathalters montiert.

Als Lichtquelle **4** für die Messanordnung ist eine breitbandige Halogenlampe vorgesehen, die sich in einem Gehäuse **6** befindet und direkt unter dem Substrathalter **2** auf der Blende **5** montiert ist. Das Gehäuse **6** ist dabei so ausgebildet, dass das Licht der Halogenlampe als gerichteter Lichtstrahl austreten kann. Die Blende **5** für die Schichtdickenverteilung wird hier gleichzeitig als Blende **5** für die Messanordnung verwendet. Die Stromzuführung zur Lichtquelle **4** erfolgt beispielsweise mit einem Kabel über eine Vakuum Stromdurchführung.

Die Lichtempfängereinheit **10** ist mit einer Halterung **15** über dem Messfenster **9** der Vakuumkammer **1** montiert. Der Lichtleiter **8** mit einer Kollimatorlinse ist dabei genau auf den Strahlengang **12** des Lichtstrahls der Lichtquelle **4** ausgerichtet. Mit der Kollimatorlinse wird das empfangene Licht im Lichtleiter **8** gebündelt und an eine Lichtdetektoreinheit weitergeleitet. Zur genauen Ausrichtung der Lichtempfängereinheit **10** weist diese Mittel zum Justieren **11** auf, beispielsweise Stellschrauben, mittels derer die Lichtempfängereinrichtung **10** genau positioniert werden kann. In der Lichtdetektoreinheit mit einem Detektorarray, werden die empfangenen Lichtsignale verstärkt und digitalisiert und können zur Auswertung an eine Prozessoreinheit übergeben werden.

Die Lichtquelle **4** und das Vakuumfenster **9** werden dabei durch die Blende **5** vor unerwünschter Beschichtung geschützt. Außerdem wird die Lichtempfängereinheit gegen Fremdlicht der Verdampfungsquellen geblockt.

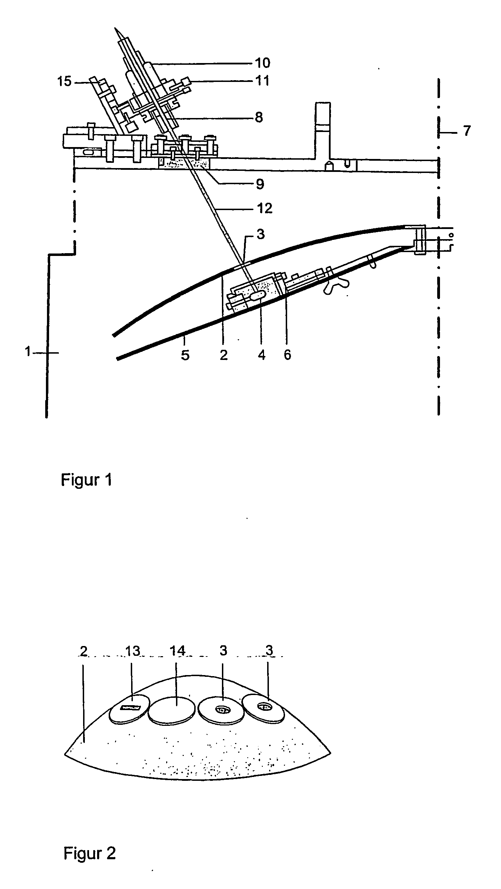

Ein Segment des Substrathalters **2,** ist wie in Fig. 2 gezeigt, zur Ausführung einer Mess-, Referenz- und Dunkelmessung mit mehreren Messeinsätzen für Substrate **3,** für eine Aussparung **13** und für einen Dunkelbereich **14** versehen, wobei die Messeinsätze auf einem Radius des Substrathalters **2** angeordnet sind, der den Strahlengang **12** schneidet. Auf weiteren Segmenten des kalottenförmigen Substrathalters **2** können dabei weitere Substrate **3** zur Beschichtung angeordnet sein. Während einer Umdrehung des Substrathalters **2** kann damit zumindest in einer Messphase eine Messung des von einem Substrat **3** transmittierten Lichtes, in einer Referenzphase eine Messung des direkt von der Lichtquelle **4** ausgestrahlten Lichtes durch die Aussparung **13** und in einer Dunkelphase eine Messung bei durch den Dunkelbereich **14** verdeckter Lichtquelle **4,** durchgeführt werden.

Zur Erfassung der Position des auf dem Substrathalter **2** angeordneten Substrates **3** für die Messphase, der Position der Aussparung **13** für die Referenzphase und der Position des Dunkelbereiches **14** für die Dunkelphase und zur Synchronisation der an die Lichtempfängereinheit **10** angeschlossenen Lichtdetektoreinheit mit dem rotierenden Substrathalter ist der Drehantrieb des Substrathalters **2** über einen starr mit dem Drehantrieb gekoppelten Inkrementalgeber und einem Zähler mit der Prozessoreinheit verbunden.

Die Auswertung der Lichtsignale erfolgt in der Prozessoreinheit in der aus den Signalen in der Mess-, Referenz- und Dunkelphase ein Wert für die Transmission des beschichteten Substrates 3 abgeleitet wird.

### BEZUGSZEICHENLISTE

- 1: Vakuumkammer
- 2: Substrathalter
- 3: Substrat
- 4: Lichtquelle
- 5: Blende
- 6: Gehäuse
- 7: Achse
- 8: Lichtleiter
- 9: Messfenster
- 10: Lichtempfängereinheit
- 11: Mittel zum Justieren
- 12: Strahlengang
- 13: Aussparung
- 14: Dunkelbereich
- 15: Halterung

## Patentansprüche

1. Messanordnung zum optischen Monitoring von Beschichtungsprozessen in einer Vakuumkammer (1) einer Beschichtungsanlage zur Schichtdickenmessung von auf Substrate (3) während des Beschichtungsprozesses aufgebrachten Schichten, welche zumindest umfasst,
- einen Lichtsender (4),
- eine im Strahlengang (12) des Lichtsenders (4) angeordnete Lichtempfängereinheit (10) und
- einen in der Vakuumkammer (1) über einer Beschichtungsquelle bewegbaren Substrathalter (2) auf dem zumindest ein zu beschichtendes Substrat (3) angeordnet oder anordenbar ist, mit weichem das zumindest eine Substrat (3) im Strahlengang (12) zwischen dem Lichtsender (4) und der Lichtempfängereinheit (10) positionierbar ist, wobei der Lichtsender (4), innerhalb der Vakuumkammer (1) zwischen dem Substrathalter (2) und einer Blende (5) angeordnet ist, welche unterhalb des Substrathalters (2) angeordnet ist, wobei die Blende (5) einen Messbereich über der Beschichtungsquelle abschattet
**dadurch gekennzeichnet, dass** die Lichtempfängereinheit (10) außerhalb der Vakuumkammer (1) und über einem Messfenster (9) der Vakuumkammer (1) angeordnet ist, wobei die Blende (5) das Messfenster (9) vor unerwünschter Beschichtung schützt und Fremdlichteinflüsse durch die Beschichtungsquelle und/oder Plasma- oder Ionenquellen verhindert.

2. Messanordnung nach Anspruch 1, **dadurch gekennzeichnet, dass** die Beschichtungsanlage für kontinuierliche Beschichtungsprozesse ausgelegt und die Blende (5) gleichzeitig zur Schichtdickenverteilung angeordnet ist.

3. Messanordnung nach einem der vorhergehenden Ansprüche, **dadurch gekennzeichnet, dass** der Lichtsender (4) auf der der Beschichtungsquelle abgewandten Seite der Blende (5) befestigt ist.

4. Messanordnung nach einem der vorhergehenden Ansprüche, **dadurch gekennzeichnet, dass** die Lichtempfängereinheit (10) Mittel zum Justieren (11) aufweist.

5. Messanordnung nach einem der vorhergehenden Ansprüche, **dadurch gekennzeichnet, dass** die Lichtempfängereinheit (10) mit einer Lichtdetektoreinheit gekoppelt ist, welche zumindest ein dispersives Element und einen Lichtdetektor umfasst, wobei über das dispersive Element die Lichtwellenlänge des dem Lichtdetektor zugeführten Lichts einstellbar ist.

6. Messanordnung nach einem der vorhergehenden Ansprüche, **dadurch gekennzeichnet, dass** der Substrathalter (2) um eine Achse (7) rotiert, wobei zumindest ein Substrat (3) auf einem Radius des Substrathalters (2) angeordnet ist.

7. Messanordnung nach Anspruch 6, **dadurch gekennzeichnet, dass** der Substrathalter (2) zumindest eine Aussparung (13) zur Freigabe eines Referenzlichtweges zwischen der Lichtquelle (4) und der Lichtempfängereinheit (10) aufweist, wobei die Aussparung (13) auf dem selben Radius wie das Substrat (3) angeordnet ist.

8. Messanordnung nach einem der Anspruch 7, **dadurch gekennzeichnet, dass** der Substrathalter (2) zumindest einen Dunkelbereich (14) zur Unterbrechung des Strahlengangs zwischen der Lichtquelle (4) und der Lichtempfängereinheit (10) aufweist, wobei der Dunkelbereich (14) auf dem selben Radius wie das Substrat (3) angeordnet ist.

9. Messanordnung nach Anspruch 7 oder 8, **dadurch gekennzeichnet, dass** der Substrathalter (2) und die Lichtdetektoreinheit mit einer Prozessoreinheit zur Erzeugung einer Messphase, einer Referenzphase und zumindest einer Dunkelphase verbunden oder verbindbar sind.

10. Verfahren zum optischen Monitoring von Beschichtungsprozessen in einer Vakuumkammer (1) einer Beschichtungsanlage zur Schichtdickenmessung von auf Substrate (3) während des Beschichtungsprozesses aufgebrachten Schichten, mittels einer Vorrichtung die einen Lichtsender (4), eine im Strahlengang (12) des Lichtsenders (4) angeordnete Lichtempfängereinheit (10) und einen in der Vakuumkammer (1) über einer Beschichtungsquelle bewegbaren Substrathalter (2) auf dem zumindest ein zu beschichtendes Substrat (3) angeordnet oder anordenbar ist, mit welchem das zumindest eine Substrat (3) im Strahlengang (12) zwischen dem Lichtsender (4) und der Lichtempfängereinheit (10) positionierbar ist, wobei der Lichtsender (4) innerhalb der Vakuumkammer (1) zwischen dem Substrathalter (2) und einer Blende (5) angeordnet ist, welche unterhalb des Substrathalters (2) angeordnet ist, umfasst, wobei mittels der Blende (7) ein Messbereich über der Beschichtungsquelle abgeschattet wird,
**dadurch gekennzeichnet, dass**
die Lichtempfängereinheit (10) außerhalb der Vakuumkammer (1) und über einem Messfenster (9) der Vakuumkammer (1) angeordnet ist, wobei durch die Blende (5) das Messfenster (9) vor unerwünschter Beschichtung geschützt wird und Fremdlichteinflüsse durch die Beschichtungsquelle und/oder Plasma- oder Ionenquellen verhindert werden

11. Verfahren nach Anspruch 10, **dadurch gekennzeichnet, dass** ein kontinuierlicher Beschichtungsprozess vorgesehen ist und die Blende (7) gleichzeitig zur Schichtdickenverteilung verwendet wird

## Claims

1. Measurement arrangement for optically monitoring coating processes in a vacuum chamber (1) in a coating plant for layer-thickness measuring of layers applied onto substrates (3) during the coating process, comprising at least:
- a light emitter (4),
- a light receiver unit (10) arranged in the beam path (12) of the light emitter (4) and
- a substrate holder (2) which can move over a coating source in the vacuum chamber (1), on which substrate holder (2) at least one substrate (3) to be coated is arranged or can be arranged and with which the at least one substrate (3) can be positioned in the beam path (12) between the light emitter (4) and the light receiver unit (10), with the light emitter (4) being arranged inside the vacuum chamber (1) between the substrate holder (2) and a screen (5) which is arranged underneath the substrate holder (2), the screen (5) shading a measurement region over the coating source,
**characterized in that** the light receiver unit (10) is arranged outside the vacuum chamber (1) and above a measurement window (9) of the vacuum chamber (1), with the screen (5) protecting the measurement window (9) against undesired coating and preventing extraneous-light influences by the coating source and/or plasma or ion sources.

2. Measurement arrangement according to Claim 1, **characterized in that** the coating plant is designed for continuous coating processes and the screen (5) is arranged at the same time for layer-thickness distribution.

3. Measurement arrangement according to one of the preceding claims, **characterized in that** the light emitter (4) is affixed on that side of the screen (5) which faces away from the coating source.

4. Measurement arrangement according to one of the preceding claims, **characterized in that** the light receiver unit (10) has means for adjusting (11).

5. Measurement arrangement according to one of the preceding claims, **characterized in that** the light receiver unit (10) is coupled to a light detector unit which comprises at least one dispersive element and a light detector, it being possible to adjust the light wavelength of the light supplied to the light detector via the dispersive element.

6. Measurement arrangement according to one of the preceding claims, **characterized in that** the substrate holder (2) rotates about an axis (7), with at least one substrate (3) being arranged on a radius of the substrate holder (2).

7. Measurement arrangement according to Claim 6, **characterized in that** the substrate holder (2) has at least one cut-out (13) for allowing a reference light path between the light source (4) and the light receiver unit (10), with the cut-out (13) being arranged on the same radius as the substrate (3).

8. Measurement arrangement according to Claim 7, **characterized in that** the substrate holder (2) has at least one dark region (14) for interrupting the beam path between the light source (4) and the light receiver unit (10), with the dark region (14) being arranged on the same radius as the substrate (3).

9. Measurement arrangement according to Claim 7 or 8, **characterized in that** the substrate holder (2) and the light detector unit are connected or can be connected to a processor unit in order to produce a measurement phase, a reference phase and at least one dark phase.

10. Method for optically monitoring coating processes in a vacuum chamber (1) of a coating plant for layer-thickness measuring of layers applied onto substrates (3) during the coating process, using an apparatus which comprises a light emitter (4), a light receiver unit (10) arranged in the beam path (12) of the light emitter (4) and a substrate holder (2) which can move over a coating source in the vacuum chamber (1), on which substrate holder (2) at least one substrate (3) to be coated is arranged or can be arranged and with which the at least one substrate (3) can be positioned in the beam path (12) between the light emitter (4) and the light receiver unit (10), with the light emitter (4) being arranged inside the vacuum chamber (1) between the substrate holder (2) and a screen (5) which is arranged underneath the substrate holder (2), the screen (5) shading a measurement region over the coating source,
**characterized in that** the light receiver unit (10) is arranged outside the vacuum chamber (1) and above a measurement window (9) of the vacuum chamber (1), with the screen (5) protecting the measurement window (9) against undesired coating and preventing extraneous-light influences by the coating source and/or plasma or ion sources.

11. Method according to Claim 10, **characterized in that** a continuous coating process is provided and the screen (5) is used at the same time for layer-thickness distribution.

## Revendications

1. Dispositif de mesure pour le monitoring optique de processus d'enduction dans une chambre à vide (1) d'une installation d'enduction pour la mesure d'épaisseur de couche de couches appliquées sur des substrats (3) pendant le processus d'enduction, lequel comprend au moins
- un émetteur de lumière (4)
- une unité réceptrice de lumière (10) disposée dans la trajectoire de faisceau (12) de l'émetteur de lumière (4) et
- un support de substrat (2) pouvant être déplacé dans la chambre à vide (1) au moyen d'une source d'enduction, sur lequel au moins un substrat (3) à enduire est disposé ou peut être disposé, avec lequel le au moins un substrat (3) peut être positionné dans la trajectoire de faisceau (12) entre l'émetteur de lumière (4) et l'unité réceptrice de lumière (10), l'émetteur de lumière (4) étant disposé à l'intérieur de la chambre à vide (1) entre le support de substrat (2) et un obturateur (5), lequel est disposé au-dessous du support de substrat (2), l'obturateur (5) obscurcissant une zone de mesure au-dessus de la source d'enduction
**caractérisé en ce que** l'unité réceptrice de lumière (10) est disposée à l'extérieur de la chambre à vide (1) et au-dessus d'une fenêtre de mesure (9) de la chambre à vide (1), l'obturateur (5) protégeant la fenêtre de mesure (9) d'une enduction inopportune et empêchant des effets de lumière parasite causés par la source d'enduction et/ou des sources de plasma ou des sources d'ions.

2. Dispositif de mesure selon la revendication 1, **caractérisé en ce que** l'installation d'enduction est conçue pour des processus d'enduction continus et l'obturateur (5) est disposé en même temps pour la répartition de l'épaisseur de couche.

3. Dispositif de mesure selon l'une quelconque des revendications précédentes, **caractérisé en ce que** l'émetteur de lumière (4) est fixé sur le côté, opposé à la source d'enduction, de l'obturateur (5).

4. Dispositif de mesure selon l'une quelconque des revendications précédentes, **caractérisé en ce que** l'unité réceptrice de lumière (10) présente des moyens pour le réglage (11).

5. Dispositif de mesure selon l'une quelconque des revendications précédentes, **caractérisé en ce que** l'unité réceptrice de lumière (10) est couplée avec une unité détectrice de lumière, laquelle comprend au moins un élément dispersif et un détecteur de lumière, la longueur d'onde de lumière de la lumière amenée au détecteur de lumière pouvant être réglée par l'élément dispersif.

6. Dispositif de mesure selon l'une quelconque des revendications précédentes, **caractérisé en ce que** le support de substrat (2) tourne autour d'un axe (7), au moins un substrat (3) étant disposé sur le rayon du support de substrat (2).

7. Dispositif de mesure selon la revendication 6, **caractérisé en ce que** le support de substrat (2) présente au moins un évidement (13) pour la libération d'un trajet de lumière de référence entre la source lumineuse (4) et l'unité réceptrice de lumière (10), l'évidement (13) étant disposé sur le même rayon que le substrat (3).

8. Dispositif de mesure selon la revendication 7, **caractérisé en ce que** le support de substrat (2) présente au moins une zone sombre (14) pour l'interruption de la trajectoire de faisceau entre la source lumineuse (4) et l'unité réceptrice de lumière (10), la zone sombre (14) étant disposée sur le même rayon que le substrat (3).

9. Dispositif de mesure selon la revendication 7 ou 8, **caractérisé en ce que** le support de substrat (2) et l'unité détectrice de lumière sont reliés ou peuvent être reliés à une unité de processeur pour générer une phase de mesure, une phase de référence et au moins une phase sombre.

10. Procédé pour le monitoring optique de processus d'enduction dans une chambre à vide (1) d'une installation d'enduction pour la mesure d'épaisseur de couche de couches appliquées sur des substrats (3) pendant le processus d'enduction, au moyen d'un dispositif qui comprend un émetteur de lumière (4), une unité réceptrice de lumière (10) disposée dans la trajectoire de faisceau (12) de l'émetteur de lumière (4) et un support de substrat (2) pouvant être déplacé dans la chambre à vide (1) au moyen d'une source d'enduction, sur lequel au moins un substrat (3) à enduire est disposé ou peut être disposé, avec lequel le au moins un substrat (3) peut être positionné dans la trajectoire de faisceau (12) entre l'émetteur de lumière (4) et l'unité réceptrice de lumière (10), l'émetteur de lumière (4) étant disposé à l'intérieur de la chambre à vide (1) entre le support de substrat (2) et un obturateur (5), lequel est disposé au-dessous du support de substrat (2), une zone de mesure au-dessus de la source d'enduction étant obscurcie au moyen de l'obturateur (7),
**caractérisé en ce que**
l'unité réceptrice de lumière (10) est disposée à l'extérieur de la chambre à vide (1) et au-dessus d'une fenêtre de mesure (9) de la chambre à vide (1), la fenêtre de mesure (9) étant protégée d'une enduction inopportune par l'obturateur (5) et des effets de lumière parasite provoqués par la source d'enduction et/ou des sources de plasma ou d'ions étant empêchés également par cet obturateur.

11. Procédé selon la revendication 10, **caractérisé en ce qu'**un processus d'enduction continu est prévu et l'obturateur (7) est utilisé simultanément pour la répartition de l'épaisseur de couche.
